# FASCICULE DE BREVET EUROPEEN

(11) **EP 3 319 114 B1**
(45) Date de publication et mention de la délivrance du brevet: **29.06.2022**
(21) Numéro de dépôt: 17168179.4
(22) Date de dépôt: 26.04.2017
(51) Int. Cl.: H01L 21/60, H01L 23/49, H01L 23/552, H01L 23/66, H01L 23/31, H01L 21/56, H01L 23/00

(54) **PROCÉDÉ DE RÉALISATION D'UNE CONNEXION ÉLECTRIQUE ENTRE UNE PUCE ÉLECTRONIQUE ET UNE PLAQUE DE SUPPORT ET DISPOSITIF ÉLECTRONIQUE**
VERFAHREN ZUR HERSTELLUNG EINER ELEKTRISCHEN VERBINDUNG ZWISCHEN EINEM ELEKTRONISCHEN CHIP UND EINER TRÄGERPLATTE, UND ELEKTRONISCHE VORRICHTUNG
PROCESS FOR MAKING AN ELECTRIC CONNECTION BETWEEN AN ELECTRONIC DIE AND AN SUPPORT PLATE AND ELECTRONIC DEVICE

(30) Priorité: 03.11.2016 FR 1660624
(43) Date de publication de la demande: 09.05.2018
(73) Titulaire: STMicroelectronics (Grenoble 2) SAS, 38000 Grenoble (FR)
(72) Inventeur: LOPEZ, Jérôme, 38134 SAINT-JOSEPH-DE-RIVIERE (FR); QUERCIA, Fabien, 38160 SAINT MARCELIN (FR); HAJJI, Asma, 38140 RIVES (FR); AUCHERE, David, 38400 SAINT MARTIN D'HERES (FR)
(74) Mandataire: Casalonga

(56) Documents cités:
- DE-A1- 2 514 011
- JP-A- H01 248 547
- JP-A- H06 268 100
- JP-A- 2000 058 579
- JP-A- 2002 064 166
- US-A1- 2004 070 065
- US-A1- 2006 097 404
- US-A1- 2010 025 864
- US-A1- 2014 103 500

## Description

La présente invention concerne le domaine des dispositifs électroniques et plus particulièrement ceux qui comprennent des puces électroniques montées sur des plaques de support, incluant des réseaux de connexion électrique ou des grilles de connexion électrique, et des fils de connexion électrique qui relient les puces aux plaques de support.

Le document JP H06 268100 décrit un dispositif électronique dans lequel une puce est installée sur le fond d'une cavité étagée d'une plaque de support et des fils de connexion électriques relient la puce et la plaque de support. Une couche diélectrique recouvre complètement la puce, la cavité et les fils. Un bloc d'encapsulation conducteur de l'électricité recouvre complètement les fils enrobés et la couche diélectrique et remplit complètement la cavité.

Le document US 2010/0025864 décrit une structure ayant des plots de masse et des plots de signal couplés à des fils de soudage, et disposée sur un composant. Un premier revêtement isole au moins les plots de signal en laissant au moins les plots de masse dégagés. Un second revêtement entoure le premier revêtement et est électriquement couplé aux plots de masse.

Le document JP2000 058579 décrit un dispositif semiconducteur ayant des fils de signal avec une inductance effective réduite et une résistance au bruit améliorée. Les fils de signal sont recouverts d'une résine conductrice reliée à la masse

Dans le cas où des fils de connexion électrique transportent des signaux notamment à des fréquences élevées, ces signaux peuvent être atténués ou peuvent être perturbés par des champs électromagnétiques environnants et/ou émettent des champs électromagnétiques qui peuvent perturber l'environnement.

A l'heure actuelle, pour réduire cette difficulté, il est proposé d'adjoindre aux dispositifs électroniques des plaques métalliques de blindage, éventuellement reliées à une masse. Néanmoins, la mise en place et la connexion électrique à une masse de telles plaques métalliques de blindage, combinées avec la réalisation de blocs d'encapsulation ou à la mise en place de couvercles d'encapsulation, posent des difficultés et sont onéreuses. De plus, comme les blindages obtenus sont globaux et à distance des fils de connexion électrique, la protection électromagnétique obtenue reste insuffisante.

Différents aspects de l'invention sont définis dans les revendications annexées.

Selon un mode de réalisation, il est proposé un procédé de réalisation d'une connexion électrique entre une puce électronique et une plaque de support sur laquelle cette puce est montée, le procédé étant selon la revendication 1.

Le procédé peut en outre comprendre les étapes suivantes :
mettre en place un fil complémentaire de connexion électrique entre un plot découvert de connexion électrique de la puce électronique et un plot découvert de connexion électrique de la plaque de support et réaliser des jonctions électriques entre les extrémités de ce fil complémentaire et ces plots, et
réaliser le blindage local conducteur de sorte que ce blindage local conducteur soit en contact avec ce fil complémentaire de connexion électrique et/ou avec au moins l'un de ces plots de connexion électrique.

Un mode de fabrication va maintenant être décrit à titre d'exemple non limitatif, illustré par le dessin annexé dans lequel :
- la figure 1 représente une vue en coupe d'un dispositif électronique en cours de fabrication, selon une étape de fabrication ;
- la figure 2 représente une vue de dessus du dispositif électronique de la figure 1 ;
- la figure 3 représente une vue en coupe du dispositif électronique en cours de fabrication, selon une étape ultérieure de fabrication ;
- la figure 4 représente une vue de dessus du dispositif électronique de la figure 3 ;
- la figure 5 représente une vue en coupe du dispositif électronique en cours de fabrication, selon une étape ultérieure de fabrication, montrant le dispositif électronique obtenu ; et
- la figure 6 représente une vue de dessus du dispositif électronique de la figure 5.

Comme illustré sur les figures, un dispositif électronique 1 comprend une plaque de support 2 et une puce électronique 3, incluant des circuits intégrés, dont une face arrière 4 est fixée sur une face avant 5 de la plaque de support 2, par l'intermédiaire d'une couche de colle (non représentée).

La plaque de support 2 est en une matière diélectrique et inclut un réseau intégré de connexion électrique 6, à un ou plusieurs niveaux métalliques, qui comprend des plots avant découverts de connexion électrique 7 et 8 de la face avant 5 et qui sont situés latéralement à distance d'un flanc 9 de la puce électronique 3 et à proximité l'un de l'autre.

La puce électronique 3 comprend des plots avant découverts de connexion électrique 10 et 11 d'une face avant 12 de cette puce électronique 3, opposée à sa face arrière 4, et qui sont situés à distance du flanc 9 de la puce électronique 3, non loin des plots avant 7 et 8 de la plaque de support 2.

On va maintenant décrire des étapes en vue de réaliser des connexions électriques entre les plots 7 et 10 et, optionnellement, les plots 8 et 11, respectivement de la plaque de support 2 et de la puce électronique 3.

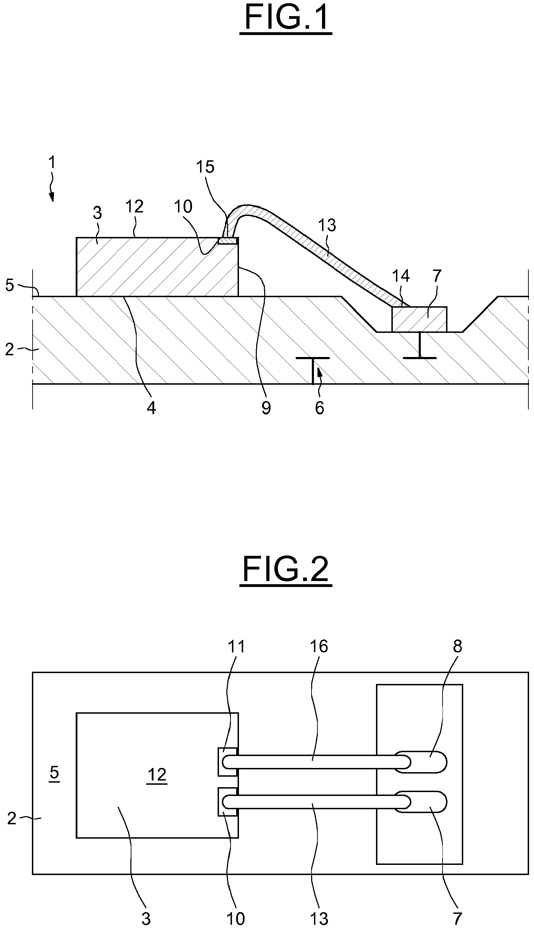

Selon une étape illustrée sur les figures 1 et 2, d'une part on met en place un fil nu de connexion électrique 13 entre les plots découverts de connexion électrique 7 et 10 et on réalise par soudure des jonctions électriques 14 et 15 respectivement entre les extrémités du fil de connexion électrique 13 et les plots 7 et 10 et, d'autre part, on met en place un fil complémentaire de connexion électrique 16 entre les plots complémentaires découverts de connexion électrique 8 et 11 et on réalise par soudure des jonctions électriques respectivement entre les portions d'extrémité du fil de connexion électrique 16 et les plots 8 et 11. Les fils de connexion électrique 13 et 16 sont voisins mais distants l'un de l'autre.

Cette opération de mise en place des fils de connexion électrique 13 et 16 peut être réalisée à l'aide d'une machine adaptée de pose et de soudage, bien connue sous le vocable anglais de « wire bonding ».

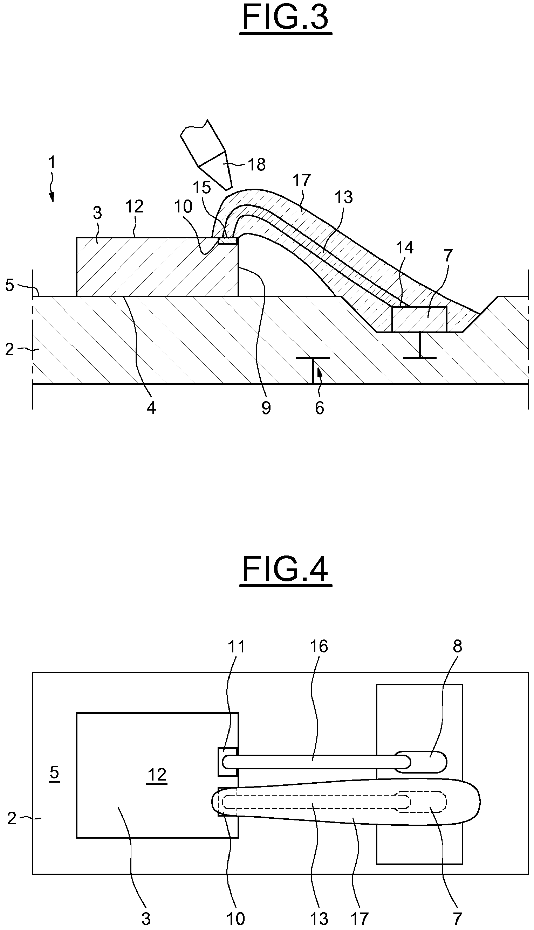

Selon une étape ultérieure illustrée sur les figures 3 et 4, on distribue localement une quantité déterminée d'une matière diélectrique liquide adhérente au-dessus du fil électrique 13, de sorte que cette matière diélectrique entoure complètement le fil de connexion électrique 13 et recouvre complètement les plots 7 et 10 et les jonctions 14 et 15. Après durcissement, cette matière diélectrique réalise un enrobage diélectrique local 17.

Cette opération est réalisée à l'aide d'un outil adapté comprenant une seringue 18 de distribution contrôlée, apte à délivrer au moins une goutte calibrée de la matière diélectrique liquide au-dessus du fil de connexion électrique 13, cette matière diélectrique liquide s'écoulant pour en fin de compte entourer le fil de connexion électrique 12 et recouvrir les plots 7 et 10 et les jonctions 14 et 15, notamment par effet de capillarité ou de mouillage.

Puis, la matière diélectrique liquide est durcie pour constituer l'enrobage diélectrique 17, soit grâce à ses qualités intrinsèques de durcissement à la température ambiante ou de durcissement sous l'effet d'une source de chaleur ou de rayonnement lumineux. Par exemple, la matière diélectrique peut être une résine époxy adaptée.

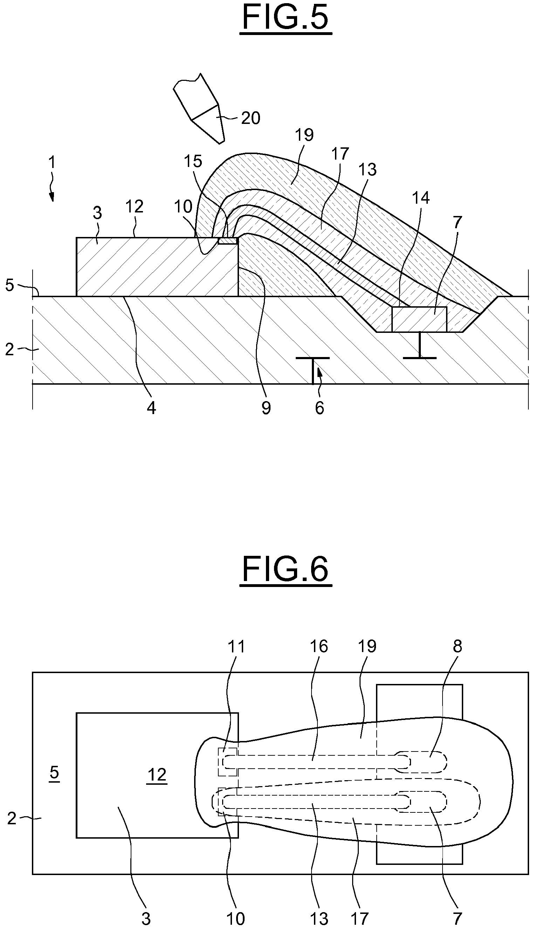

Selon une étape ultérieure illustrée sur les figures 5 et 6, on distribue localement une quantité déterminée d'une matière liquide adhérente conductrice de l'électricité au-dessus de l'enrobage diélectrique 17 et éventuellement du fil de connexion électrique 16, de sorte que cette matière conductrice entoure complètement l'enrobage diélectrique 17 et soit en contact avec le fil de connexion électrique 16 et/ou les plots 8 et 11, cette matière conductrice débordant éventuellement sur les faces avant 5 et 12 de la plaque de support 2 et de la puce électronique 3. Après durcissement, cette matière conductrice réalise un blindage local conducteur de l'électricité 19 au plus près du fil de connexion électrique 13 et relié au fil de connexion électrique 16 et aux plots 8 et 11.

Cette opération est réalisée à l'aide d'un outil contrôlé adapté comprenant une seringue 20 de distribution contrôlée, apte à délivrer au moins une goutte calibrée de la matière conductrice liquide, cette matière conductrice liquide s'écoulant notamment par effet de capillarité ou de mouillage.

Puis, la matière conductrice liquide est durcie pour constituer le blindage local conducteur 19, grâce à ses qualités intrinsèques de durcissement à la température ambiante ou de durcissement sous l'effet d'une source de chaleur ou de rayonnement lumineux. Par exemple, la matière conductrice peut être une résine époxy chargée de particules métalliques.

Le dispositif électronique 1 final est alors obtenu.

Le fil de connexion électrique 13 est destiné au transport de signaux électriques entre les plots 7 et 10 de la plaque de support 2 et de la puce électronique 3. Le blindage conducteur 19 constitue une protection électromagnétique de ces signaux électriques.

Les plots 8 et 11, reliés par le fil de connexion électrique 16, constituent des plots de masse des circuits électriques du dispositif électronique 1. Ainsi, le blindage conducteur 19, qui est relié aux plots 8 et 11 et au fil de connexion électrique 16, est relié à la masse des circuits électriques du dispositif électronique 1.

Selon une variante de réalisation, le fil de connexion électrique 16 pourrait être supprimé.

Bien entendu, le dispositif électronique 1 peut comprendre d'autres fils de connexion électrique 13 reliant d'autres plots 7 et 10 de la plaque de support 2 et de la puce électronique 3 et d'autres fils de connexion électrique 16 reliant d'autres plots 8 et 11 de la plaque de support 2 et de la puce électronique 3, également équipés d'enrobages diélectriques locaux 17 et de blindages conducteurs locaux 19, dont les étapes de réalisation seraient respectivement communes.

Selon une variante de réalisation, la plaque de support 2 pourrait comprendre une grille métallique comprenant une plateforme sur laquelle serait montée la puce électronique 3, les fils de connexion électrique 13 et 16 reliant la puce électronique 3 à des pattes périphériques de cette grille.

## Revendications

1. Procédé de réalisation d'une connexion électrique entre une puce électronique (3) et une plaque de support (2) sur laquelle cette puce est montée, comprenant les étapes suivantes :
mettre en place un fil de connexion électrique (13) entre un plot découvert de connexion électrique (10) de la puce électronique et un plot découvert de connexion électrique (7)
de la plaque de support et réaliser des jonctions électriques (14,15) entre les extrémités du fil et les plots,
réaliser un enrobage local diélectrique (17) en une matière diélectrique, qui entoure le fil de connexion électrique (13) et recouvre les plots (7,10) et les jonctions, par distribution locale d'une quantité déterminée de la matière diélectrique à l'état liquide, sous la forme d'une goutte calibrée qui s'écoule par effet de capillarité ou de mouillage, à l'aide d'un outil contrôlé comprenant une seringue de distribution contrôlée (18), et durcissement de cette matière diélectrique, et
réaliser un blindage local conducteur (19) en une matière conductrice de l'électricité, qui recouvre ledit enrobage local diélectrique, par distribution locale d'une quantité déterminée d'une matière conductrice de l'électricité à l'état liquide, sous la forme d'une goutte calibrée qui s'écoule par effet de capillarité ou de mouillage, à l'aide d'un outil contrôlé comprenant une seringue de distribution contrôlée (20), et durcissement de cette matière conductrice.

2. Procédé selon la revendication 1, comprenant les étapes suivantes :
mettre en place un fil complémentaire de connexion électrique (16) entre un plot découvert de connexion électrique (11) de la puce électronique et un plot découvert de connexion électrique (8) de la plaque de support et réaliser des jonctions électriques entre les extrémités de ce fil complémentaire et ces plots, et
réaliser le blindage local conducteur (19) de sorte que ce blindage local conducteur (19) soit en contact avec ce fil complémentaire de connexion électrique (16) et/ou avec au moins l'un de ces plots de connexion électrique.

## Patentansprüche

1. Verfahren zur Herstellung einer elektrischen Verbindung zwischen einem elektronischen Chip (3) und einer Trägerplatte (2), auf der dieser Chip montiert ist, die folgenden Schritte umfassend:
Installieren eines elektrischen Verbindungsdrahtes (13) zwischen einem unbedeckten elektrischen Verbindungskontakt (10) des elektronischen Chips und
einem unbedeckten elektrischen Verbindungskontakt (7) der Trägerplatte und Herstellen elektrischer Übergänge (14,15) zwischen den Enden des Drahtes und den Kontakten,
Herstellen einer lokalen dielektrischen Umhüllung (17), aus einem dielektrischen Material, die den elektrischen Verbindungsdraht (13) umgibt und die Kontakte (7,10) und
die Übergänge bedeckt, durch lokale Verteilung einer bestimmten Menge des dielektrischen Materials in flüssigem Zustand in der Form eines geeichten Tropfens, der durch Kapillar- oder Benetzungswirkung fließt, unter Verwendung eines kontrollierten Werkzeugs, das eine Spritze mit kontrollierter Verteilung (18) umfasst, und Aushärten dieses dielektrischen Materials und
Herstellen einer lokalen leitenden Abschirmung (19), aus einem elektrisch leitenden Material, die die lokale dielektrische Umhüllung bedeckt, durch lokale Verteilung einer bestimmten Menge eines elektrisch leitenden Materials in flüssigem Zustand in Form eines geeichten Tropfens, der durch Kapillar- oder Benetzungswirkung fließt, unter Verwendung eines kontrollierten Werkzeugs, das eine Spritze mit kontrollierter Verteilung (20) umfasst, und Aushärten dieses leitenden Materials.

2. Verfahren nach Anspruch 1, die folgenden Schritte umfassend:
Installieren eines komplementären elektrischen Verbindungsdrahtes (16) zwischen einem unbedeckten elektrischen Verbindungskontakt (11) des elektronischen Chips und einem unbedeckten elektrischen Verbindungskontakt (8) der Trägerplatte und Herstellen von elektrischen Übergängen zwischen den Enden dieses komplementären Drahtes und diesen Kontakten, und
Herstellen der lokalen leitenden Abschirmung (19), so dass diese lokale leitende Abschirmung (19) mit diesem komplementären elektrischen Verbindungsdraht (16) in Kontakt steht und/oder mit mindestens einem dieser elektrischen Verbindungskontakte.

## Claims

1. A method for making an electrical connection between an electronic chip (3) and a support plate (2) on which this chip is mounted, comprising the following steps:
placing an electrical connection wire (13) between an exposed electrical connection pad (10) of the electronic chip and an exposed electrical connection pad (7) of the support plate and
making electrical junctions (14, 15) between the ends of the wire and the pads,
producing a local dielectric coating (17) made of a dielectric material, which surrounds the electrical connection wire (13) and covers the pads (7, 10) and the junctions, by local distribution of a determined amount of the dielectric material in the liquid state, in the form of a calibrated drop which flows by capillarity or wetting effect, using a controlled tool comprising a controlled dispensing syringe (18), and hardening this dielectric material, and
producing a local conductive shield (19) from an electrically conductive material, which covers said local dielectric coating, by local distribution of a determined amount of an electrically conductive material in the liquid state, in the form of a calibrated drop which flows by capillarity or wetting effect, using a controlled tool comprising a controlled dispensing syringe (20), and hardening this conductive material.

2. The method according to claim 1, comprising the following steps:
placing a complementary electrical connection wire (16) between an exposed electrical connection pad (11) of the electronic chip and an exposed electrical connection pad (8) of the support plate and making electrical junctions between the ends of this complementary wire and these pads,
and
producing the local conductive shield (19) so that this local conductive shield (19) is in contact with this complementary electrical connection wire (16) and/or with at least one of these electrical connection pads.
